# EUROPEAN PATENT SPECIFICATION

(11) **EP 0 507 400 B1**
(45) Date of publication and mention of the grant of the patent: **18.09.1996**
(21) Application number: 92200899.0
(22) Date of filing: 30.03.1992
(51) Int. Cl.: H01L 21/365, H01L 21/471

(54) **Method of producing epitaxial layers of II-VI semiconductors with high acceptor concentrations**
Verfahren zur Erzeugung von epitaktischen II-VI-Halbleiterschichten mit hohen Akzeptor-Konzentrationen
Méthode pour produire des couches épitaxiales de semi-conducteurs II-VI présentant une forte concentration en accepteurs

(30) Priority: 03.04.1991 US 680179
(43) Date of publication of application: 07.10.1992
(73) Proprietor: Philips Electronics N.V., 5621 BA Eindhoven (NL)
(72) Inventor: Khan, Babar, NL-5656 AA Eindhoven (NL); Taskar, Nikhil, NL-5656 AA Eindhoven (NL)
(74) Representative: Rensen, Jan Geert

(56) References cited:
- MATERIALS RESEARCH SOCIETY SYMPOSIUM PROCEEDINGS, VOL. 144 : ADVANCES IN MATERIALS, PROCESSING AND DEVICES IN III-V COMPOUNDS SEMICONDUCTORS, BOSTON MA, USA, 28 NOV.-5 DEC. 1988 pages 391 - 396 SKROMME ET AL 'Rapid thermal annealing and ion implantation of heteroepitaxial ZnSe/GaAs'
- EXTENDED ABSTRACTS vol. 89, no. 2, 1989, PRINCETON, NEW JERSEY US page 642 SKROMME ET AL 'Ion implantation, rapid thermal annealing, and damage effects in heteroepitaxial ZnSe/GaAs'
- JOURNAL OF CRYSTAL GROWTH. vol. 99, no. 1-4, January 1990, AMSTERDAM NL pages 413 - 417 OHKI ET AL 'High concentration nitrogen doping in MOVPE grown ZnSe'
- JOURNAL OF CRYSTAL GROWTH. vol. 107, no. 1-4, January 1991, AMSTERDAM NL pages 679 - 682 SUEMUNE ET AL 'Doping of nitrogen in ZnSe films : improved doping properties in ZnSe/ZnSSe periodic layered structures grown on GaAs by MOVPE'
- APPLIED PHYSICS LETTERS. vol. 52, no. 1, 4 January 1988, NEW YORK US pages 57 - 59 YASUDA ET AL 'Metalorganic vapor phase epitaxy of low resistivity p-type ZnSe'

## Description

This invention relates to a process for producing epitaxial layers of II-VI semiconductor compounds, having high concentrations of acceptor-type impurities.

As is known, semiconductors are characterized as either n-type or p-type, depending upon whether the predominant carriers in the material are electrons or holes. As is also known, semiconductors can be rendered n-type or p-type by substituting impurity atoms (dopants) for atoms of the host lattice which have a different valence. Donor-type impurities are those which give electrons, and thus render the host material n-type, while acceptor-type impurities are those which receive electrons, and thus render the host p-type.

Successful doping to obtain or enhance n-type or p-type conductivity depends not only upon the ability to introduce a sufficient amount of the proper dopant into the semiconductor material, but also upon the ability to position the dopant atoms in the proper substitutional sites within the material's crystal lattice where they can give or receive electrons.

Dopants which do not readily assume the proper substitutional sites in sufficient number can he activated, *i.e.* converted to donors or acceptors, *e.g*., by a thermal anneal of the doped semiconductor material.

Another important consideration is the presence of other impurities in the semiconductor material which are, or are capable of assuming, an opposite conductivity type than that intended, thus compensating the effect of the dopant. Thus, it is actually the net donor or acceptor concentration which determines the overall conductivity of the material.

Semiconductors which can easily be rendered either n- or p-type, such as Si, from Group IVA of the Periodic Table, and GaAs, a III-V compound, so-called because it is made up of elements from Groups IIIA and VA of the Periodic Table, can be converted to devices such as diodes by doping adjacent regions p- and n-type to form pn junctions.

II-VI compounds such as ZnS and ZnSe are of interest for such devices because of their relatively wide band gaps. For example, being able to form a doped junction in an epitaxial layer of ZnSe could result in a blue-emitting LED or laser.

However, in practice, it has proved extremely difficult to obtain stable p-type ZnSe epitaxial layers. While a sufficient amount of dopant can usually be introduced into the layers, it is either difficult to convert sufficient numbers of the dopant atoms into acceptors, or the acceptors are unstable. For example, lithium-doped epitaxial layers of ZnSe can be converted to p-type material (defined herein as a material having a net acceptor concentration greater than 1x10¹⁴ acceptors or holes per cc)., but lithium is unstable because of its tendency to diffuse, even at relatively low temperatures.

Nitrogen would be a more stable acceptor than lithium, and can be doped into ZnSe in situ in high concentrations (10¹⁹/cc using metal organic chemical vapour deposition (MOCVD). However, only a small fraction of it (up to 1x10¹⁴/cc) can be activated.

Greater success has been achieved using chemical beam epitaxy (CBE). That is, starting with an as-grown dopant concentration of about 10¹⁹, a net acceptor concentration in the range of 10¹⁶ to 10¹⁷ has been achieved. However, the technique requires relatively expensive equipment and the conversion efficiency is relatively low.

Dopants are usually activated by a carefully controlled thermal treatment such as a furnace anneal, which allows the dopant ions to relax into the correct substitutional sites in the host lattice.

Rapid thermal annealing (RTA) has been employed as an alternative to furnace annealing to activate shallow acceptor implants of N in ZnSe heteroepitaxial layers on GaAs, in order to minimize degradation of the material by interdiffusion. In addition, a diffusion-limiting capping layer of SiO2 or Si3N4 was employed as further protection from degradation. Samples annealed at 600 degrees C and above did not exhibit p-type behaviour. Also, no evidence of N acceptors was observed in the PL spectra. Samples annealed at 500 degrees C showed evidence of N acceptor in the PL spectra, but were not p-type. " Rapid Thermal Annealing and Ion Implantation of Heteroepitaxial ZnSe/GaAs", B.J. Skromme et. al., Bellcore, MRS Proceedings, 1989, Vol. 144, pages 391-396.

It is an object of the invention to provide p-type epitaxial layers of ZnS, ZnSe or Zn(S,Se) semiconductor compounds.

It is a further object of the invention to provide a method for producing such layers.

In accordance with one aspect of the invention, such a layer is obtained by in-situ doping the layer with N acceptor-type impurity, capping the layer with a diffusion-limiting layer, and subjecting the resultant structure to a rapid thermal anneal (RTA) at a temperature within the range of about 700 to 950 degrees C for a period of from 10 sec. at a temperature of 950°C to 2 minutes at a temperature of 700°C.

In accordance with a preferred embodiment of the invention, the capping layer is selected from the group consisting of SiO2 and Si3N4.

The rapid thermal anneal should be carried out for a time sufficient to result in substantial conversion of the impurity dopant to acceptors, but insufficient to result in substantial degradation of the epi layer, due for example to inter-diffusion across the surfaces of the layer, and/or out-diffusion from the capping layer.

It will be appreciated that based on the above considerations, the maximum allowable time at any one temperature within the above range will be shorter at higher temperatures. Thus, the time should not exceed 10 seconds at 950 degrees C., but may be as long as 2 minutes at 700 degrees C.

The invention will be described more fully with reference to the drawing in which
Fig. 1 is a cross-section of one embodiment of a structure of the invention including an epitaxial layer of a II-VI semiconductor compound on a substrate, and a diffusion-limiting layer on the epitaxial layer;
Fig. 2 is a time-temperature graph of a typical rapid thermal anneal (RTA) of the invention;
Fig. 3 is a cross-section similar to that of Fig. 1, in which the diffusion-limiting layer has been removed following a rapid thermal anneal of the structure;
Fig. 4 is a plot of a photoluminescence (PL) spectrum for an epitaxial layer of the invention prior to RTA; and
Fig. 5 is a plot similar to that of Fig. 4 obtained for the same layer after RTA.

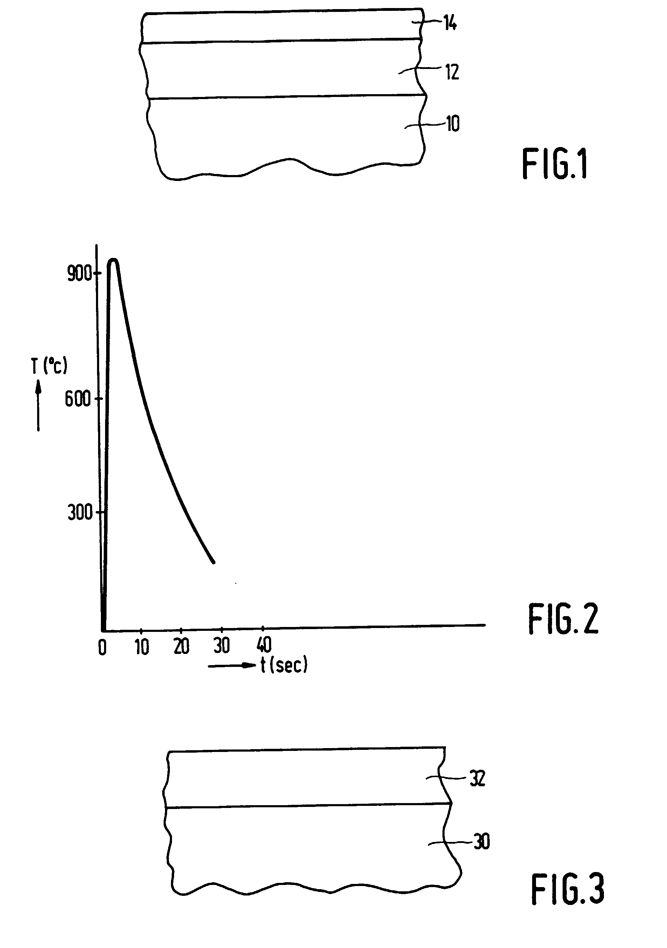

Referring to Fig. 1, there is shown an epitaxial layer 12 of a II-VI semiconductor compound such as ZnS, ZnSe, or Zn(S,Se), which has been grown on a suitable substrate 10 such as GaAs. Deposited on top of the epitaxial layer 12 is a cap 14 of a diffusion limiting layer of a material such as SiO2 or Si3N4.

Incorporated into the epi layer 12 is a concentration of a stable acceptor-type impurity such as N. This impurity is introduced by in-situ doping, *i.e*. introduced during growth of the epi layer, *e.g*., by growing the layer in the presence of ammonia. This method of doping enables the introduction of sufficient concentration of dopant at suitable sites within the lattice of host crystal, so that upon subjecting these sites to a rapid thermal anneal, a substantial number of the dopant ions at these sites relax into the correct substitutional sites for activation. Growth of the epi layer is preferably by chemical vapour deposition (CVD).

The capping layer 14 is essential to prevent out-diffusion of Zn and S or Se from the epi layer, and also to suppress the diffusion of Ga or other mobile species from the substrate into the epi layer during RTA. As is known, Ga is a donor-type impurity in II-VI compounds, so that its presence in the epi layer would result in undesirable compensation of the acceptors.

After completion of the RTA, the capping layer 14 may be removed, as shown in Fig. 3, provided it serves no other purpose.

Fig. 2 shows a typical time/temperature relationship (triangular profile) for an RTA carried out using a lamp annealing system. As seen from the graph, a peak temperature of 950 degrees C is reached in about 5 seconds, after which the lamp is turned off, causing the temperature to decline to below 200 degrees C in less than 25 seconds. Alternative methods of carrying out an RTA include pulsed graphite heater annealing and pulsed laser annealing.

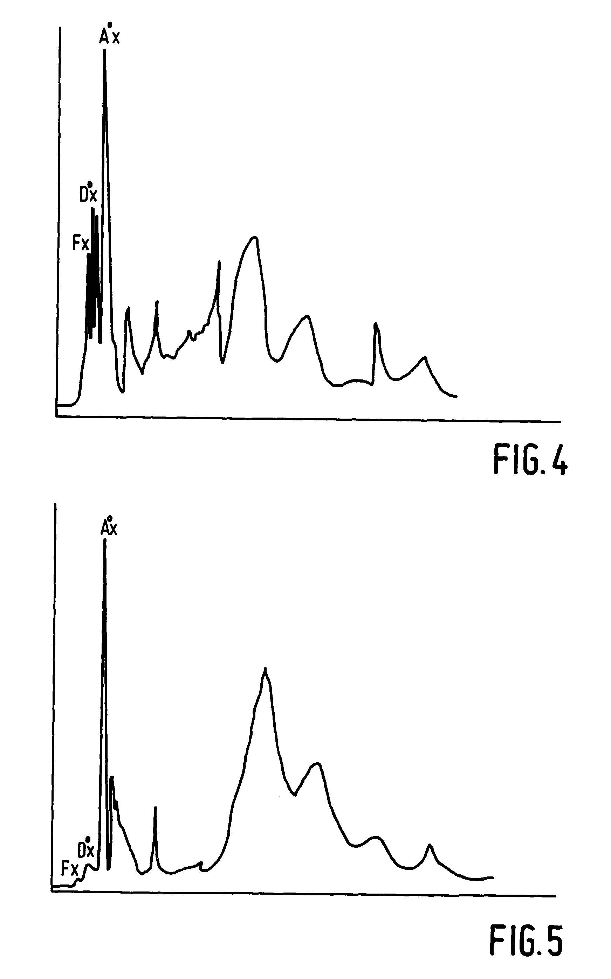

By way of example epitaxial layers of ZnSe were grown on GaAs substrates using MOCVD and doped with N in situ using ammonia. Subsequently, an SiO2 capping layer was sputtered onto the epi layer, and the resultant structure subjected to a lamp anneal having the profile shown in Fig. 2. The epi layers were characterized by photoluminescence (PL) before and after RTA. Results are shown in Figs. 4 and 5, in which PL intensity in arbitrary units is plotted versus excitation wavelength in Angstroms. As may be seen in Fig. 4, before RTA the relative intensity of acceptor bound excitons (A°x) and donor bound excitons (D°x) to free excitons (Fx) is about 5 and 3, respectively. The relatively large presence of shallow donors is characteristic of NH3-doped layers. Fig. 5 shows that after RTA, the A°x to Fx ratio has increased to about 25, while the D°x to Fx ratio has remains unchanged, indicating that the net acceptor concentration has been increased as a result of the RTA.

Capacitance versus voltage (C-V) measurements were also carried out before and after RTA, using the technique described by T. Marshall et al. in "DC and AC Transport in Molecular Beam Epitaxy Grown Metal/ZnSe/GaAs Heterojunction Structures", J. Appl. Phys., 66 (4), Aug. 15, 1989, pages 1753-1758; and "Electrical Characterization of p-type ZnSe:Li Epilayers Grown on p⁺ GaAs by Molecular Beam Epitaxy", J. Appl. Phys., 69(7), Apr. 1, 1991, pages 4149-4151. Before RTA, the samples were fully depleted, indicating a net acceptor concentration too low to measure. After RTA, the net acceptor concentration had increased to about 1x10¹⁶ per cc.

Additional samples of epitaxial ZnSe layers, grown on GaAs substrates, doped with N and capped with SiO2 layers were prepared, either by MOCVD or flow modulation epitaxy (herein FME... FME), a variation of MOCVD in which growth of the epitaxial layer is periodically interrupted to introduce a layer of dopant.

The samples were divided into sets and subjected to rapid thermal annealing at various temperatures using lamp annealing to achieve a triangular temperature profile like that shown in Fig. 2. The so-treated samples were then measured for net acceptor concentration, using the C-V technique. Results are shown in the following Table.

**TABLE**

| RTA | | | | | | |
|---|---|---|---|---|---|---|
| Set No. | Peak Temp °C / Net Acceptor Conc. (per cc) | | | | | |
| | 725 | 780 | 825 | 850 | 900 | 950 |
| 1 | 3x10¹⁵ | - | - | - | - | - |
| 2* | - | 1.5x10¹⁶ | 1.4x10¹⁶ | 1.6x10¹⁶ | - | 1x10¹⁶ |
| 3 | 1x10¹⁵ | 1.5x10¹⁶ | 2x10¹⁶ | - | 2x10¹⁶ | 5x10¹⁵ |
| 4* | 1x10¹⁵ | 1.8x10¹⁶ | - | - | - | - |
| 5 | - | - | - | - | - | 1x10¹⁶ |

| | | | | | | |
|---|---|---|---|---|---|---|
| * indicates prepared by FME. | | | | | | |

As may be seen from the Table, p-type material was obtained for all samples subjected to a peak temperature in the range of 725 to 950 degrees C.

To demonstrate the effects of other temperature profiles, samples from set 3 were subjected to RTAs in which the lamp power was controlled to achieve and hold a peak temperature of 700 degrees C for 10 and 30 seconds, respectively. Net acceptor concentrations of 1x10¹⁵ and 8x10¹⁵/cc, respectively, were obtained.

An RTA at a peak temperature of 600 degrees C for 10 seconds gave no measurable value of net acceptor concentration for any sample.

While there have been shown and described what are at present considered to be the preferred embodiments of the invention, it will be apparent to those skilled in the art that various changes and modifications may be made therein without departing from the scope of the invention as defined by the appended claims.

## Claims

1. Method for obtaining a p-type epitaxial layer of a ZnSe-, a ZnS- or a Zn(Se,S) compound, the method comprising forming an epitaxial layer of the compound by chemical vapour deposition, in-situ doping the layer with the acceptor-type impurity N, capping the epitaxial layer with a diffusion-limiting layer and subjecting the resultant structure to a rapid thermal anneal at a temperature of 700 to 950 °C for a period of from 10 sec at a temperature of 950 °C to 2 minutes at a temperature of 700 °C.

2. Method of claim 1, in which the diffusion-limiting layer is formed of Si₃N₄ or SiO₂.

## Patentansprüche

1. Verfahren zur Herstellung einer p-leitenden, epitaktischen Schicht aus einer ZnSe-, einer ZnS- oder einer Zn(Se,S)-Verbindung, wonach eine epitaktische Schicht der Verbindung durch Gasphasenabscheidung nach chemischem Verfahren ausgebildet, die Schicht mit dem Akzeptorfremdatom N in situ dotiert, die epitaktische Schicht mit einer diffusionsbegrenzenden Schicht versehen und die sich ergebende Struktur bei einer Temperatur von 700 bis 950 °C während einer Zeitdauer von 10 Sekunden, bei einer Temperatur von 950 °C, bis zu 2 Minuten, bei einer Temperatur von 700°C, einer Kurzzeitausheilung unterworfen wird.

2. Verfahren nach Anspruch 1, bei welchem die diffusionsbegrenzende Schicht aus Si₃ N₄ oder SiO₂ gebildet wird.

## Revendications

1. Procédé d'obtention d'une couche épitaxiale de type p d'un composé ZnSe, ZnS ou Zn(Se,S), le procédé comprenant la formation d'une couche épitaxiale du composé par dépôt de vapeur chimique, dopage in situ de la couche avec des impuretés N du type accepteur, recouvrement de la couche épitaxiale avec une couche limitant la diffusion et exposition de la structure obtenue à un recuit thermique rapide à une température de 700 à 950°C pendant une période allant de 10 secondes à une température de 950°C à 2 minutes à une température de 700°C.

2. Procédé selon la revendication 1, dans lequel la couche limitant la diffusion est formée de Si₃N₄ ou SiO₂.
